# EUROPEAN PATENT APPLICATION

(11) **EP 2 023 405 A1**
(43) Date of publication of application: **11.02.2009**
(21) Application number: 07740859.9
(22) Date of filing: 03.04.2007
(51) Int. Cl.: H01L 31/10, H01L 27/14, H01L 27/06, H01L 21/8222

(54) **OPTICAL SEMICONDUCTOR DEVICE AND METHOD FOR MANUFACTURING SAME**

(30) Priority: 24.05.2006 JP 2006143985
(71) Applicant: Panasonic Corporation, Kadoma-shi Osaka 571-8501 (JP)
(72) Inventor: IWAI, Takaki c/o Panasonic Corporation IP Development Center, Chou-ku, Osaka-shi, Osaka 540-6207 (JP)
(74) Representative: TER MEER - STEINMEISTER & PARTNER GbR
(86) International application number: PCT/JP2007/057423
(87) International publication number: WO 2007/135810

(57) **Abstract**

An optical semiconductor device is provided with an n-type epitaxial layer (second epitaxial layer) 24 having a low dopant concentration formed on a low concentration p-type silicon substrate 1; a p-type anode layer (first diffusion layer) 25 having a low dopant concentration selectively formed in the n-type epitaxial layer 24 by means of the ion implantation or the like; a high concentration n-type cathode layer (second diffusion layer) 9 formed on the anode layer 25; a light receiving element 2 comprising the anode layer 25 and the cathode layer 9; and a transistor 3 formed on the n-type epitaxial layer 24. Aphotodiode **characterized in** its high speed and high receiving sensitivity for light having a short wavelength and a transistor **characterized in** its high speed can be mounted on the same semiconductor substrate.

## Description

### FIELD OF THE INVENTION

The present invention relates to an optical semiconductor device provided with a light receiving element and a transistor on a same substrate, and a method for manufacturing the semiconductor device.

### BACKGROUND OF THE INVENTION

A light receiving element is an element used for converting an optical signal into an electrical signal and used in various fields. In the field of optical discs such as CD (compact disc) and DVD (digital versatile disc), in particular, the light receiving element is importantly a key device in an optical head device (optical pickup) which reads and writes a signal recorded on the optical disc. As a higher performance and a higher integration have been increasingly demanded in recent years, a so-called opto-electronic integrated circuit (OEIC) provided with a photo diode which is the light receiving element and other various electronic elements such as a bipolar transistor, a resistance and a capacitance is being developed. It is demanded that a light receiving element characterized in its high receiving sensitivity, high speed and low noise, and a bipolar transistor characterized in its high speed and high performance be provided in the OEIC. As a recent trend, the commercialization of products such as Blu-ray Disc (BD) and HD-DVD, in which a blue semiconductor laser (wavelength of 405 nm) is used as a light source, has started in response to a demand for a larger capacity of the optical disc. Accordingly, the development of an OEIC which achieves a high speed and a high receiving sensitivity in a short wavelength region corresponding to the blue semiconductor laser is awaited.

Below is described a conventional optical semiconductor device.

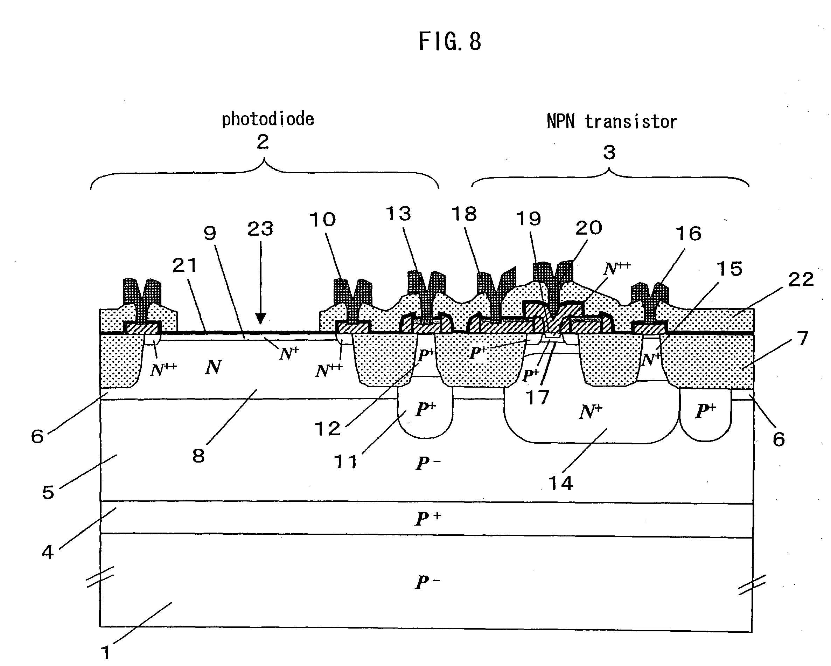

Fig. 8 is a schematic sectional view of an optical semiconductor device (OEIC) having a conventional structure. In the example of the drawing is illustrated an OEIC provided with a silicon substrate as a semiconductor substrate, a double polysilicon emitter high-speed NPN transistor as a bipolar transistor and a pin photodiode as a light receiving element on the same substrate.

Referring to reference numerals shown therein, 1 denotes a low concentration p-type silicon substrate, 2 denotes a photodiode formed on the substrate 1, 3 denotes an NPN transistor formed on the silicon substrate 1, 4 denotes a high concentration p-type embedding layer formed on the silicon substrate 1, 5 denotes a low concentration p-type epitaxial layer formed on the p-type embedding layer 4, 6 denotes an n-type epitaxial layer formed on the p-type epitaxial layer 5, and 7 denotes a LOCOS isolation layer formed on the n-type epitaxial layer 6.

In the photodiode 2, 8 denotes a cathode layer made of the n-type epitaxial layer 6, 9 denotes a cathode contact layer formed on the cathode layer 8, 10 denotes a cathode electrode selectively formed on the cathode contact layer 9, 11 denotes an anode embedding layer formed in an interface between the p-type epitaxial layer 5 and the n-type epitaxial layer 6, 12 denotes an anode contact layer formed on the anode embedding layer 11, and 13 denotes an anode electrode formed on the anode contact layer 12.

In the NPN transistor 3, 14 denotes a high concentration n-type collector embedding layer formed in an interface between the p-type epitaxial layer 5 and the n-type epitaxial layer 6, 15 denotes a collector contact layer selectively formed on the collector embedding layer 14, 16 denotes a collector electrode formed on the collector contact layer 15, 17 denotes a base layer selectively formed in the n-type epitaxial layer 6 on the collector embedding layer 14, 18 denotes abase electrode connected to the base layer 17, 19 denotes an emitter layer selectively formed on the base layer 17 , and 20 denotes an emitter electrode formed on the emitter layer 19.

21 denotes a first insulation film formed on the n-type epitaxial layer 6, 22 denotes a second insulation film formed on the first insulation film 21, and 23 denotes a light receiving surface in which the second insulation film 22 of the photo diode 2 is selectively removed so that the first insulation film 21 is exposed. The light receiving surface 23 is used as a reflection preventing film for reducing the reflection of an incident light in the interface by optimizing a thickness and a refractive index of the first insulation film 21.

An operation of the OEIC thus constituted is described below.

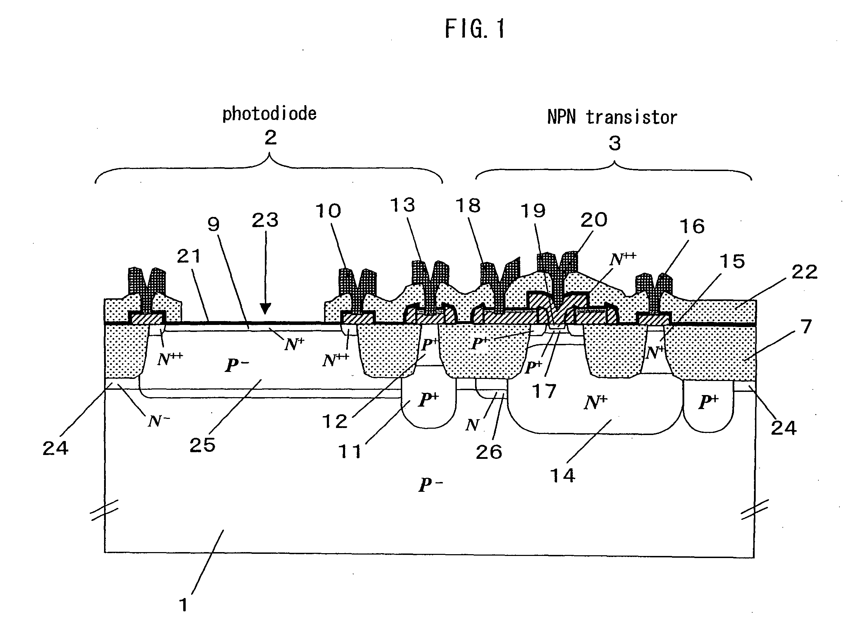

The light enters through the light receiving surface 23 and is absorbed by the cathode layer 8 and the p-type epitaxial layer 5 which is an anode. As a result, electron-hole pairs are generated. When a reverse bias is applied to the photo diode 2 at the time, a depletion layer extends on the side of the p-type epitaxial layer 5 in which the dopant concentration is low. Of the electron-hole pairs generated in the vicinity of the depletion layer, the electrons and the holes are diffused and drifted and separately arrive at the cathode contact layer 9 and the anode embedding layer 11, respectively. Then, carries are retrieved as optical current from the cathode electrode 10 and the anode electrode 13. The optical current is amplified and signal-processed by an electronic circuit comprising the NPN transistor 3 and the resistance element and capacitance element provided on the silicon substrate 1, and then outputted as recording and reproduction signals for the optical disc.
PATENT DOCUMENT: 2005-183722 of the Japanese Patent
Applications Laid-Open (Pages 5-6, Fig. 1)

### DISCLOSURE OF THE INVENTION

### PROBLEMS TO BE SOLVED BY THE INVENTION

In the structure according to the conventional technology, however, the optical current in the photodiode 2 is roughly divided into diffusion current components and drift current components. The diffusion current is dominated by the diffusion of minority carriers up to the end of the depletion layer. Therefore, a response speed of the diffusion current component is lower than that of the drift current component resulting from an electrical field in the depletion layer. Further, there are some carriers which are recombined before reaching the depletion layer, thereby failing to contribute to the optical current. More specifically, the diffusion current may cause the deterioration of a frequency characteristic and receiving sensitivity of the photodiode 2.

The percentage of the carriers absorbed in a surface vicinity is increased as the optical wavelength is shorter. In the case of silicon, for example, the depth of approximately 11 µm is necessary in order to obtain the carrier absorption ratio of 95% in the red light having the wavelength of 650 nm which is used as the light source for DVD, while the absorption ratio at the same level can be obtained in the depth of approximately 0.8 µm in the case of the blue light having the wavelength of 405 nm. Thus, a large influence is observed in the light having a short wavelength in the vicinity of the silicon surface.

The present invention was made in order to solve the conventional problems, and a main object of the present invention is to provide an optical semiconductor device provided with a light receiving element characterized in its high speed and high receiving sensitivity for blue light and a transistor characterized in its high speed on the same substrate.

### MEANS FOR SOLVING THE PROBLEMS

1) A first optical semiconductor device according to the present invention is an optical semiconductor device provided with a light receiving element and a transistor on the same substrate, comprising:
a second epitaxial layer of a second conductivity type having a low dopant concentration formed on a semiconductor substrate of a first conductivity type;
a first diffusion layer of the first conductivity type having a low dopant concentration selectively formed on the second epitaxial layer; and
a second diffusion layer of the second conductivity type having a high dopant concentration formed at an upper section of the first diffusion layer, wherein
the first and second diffusion layers constitute the light receiving element, and the transistor is formed in the second epitaxial layer.

The "second" recited in the second epitaxial layer corresponds to a second epitaxial layer in the constitution 2) comprising a first epitaxial layer and a second epitaxial layer described later.

A method for manufacturing an optical semiconductor device according to the present invention corresponding to the first semiconductor device is a method for manufacturing an optical semiconductor device provided with a light receiving element and a transistor on the same substrate, comprising:
a step for forming a second epitaxial layer of a second conductivity type having a low dopant concentration on a semiconductor substrate of a first conductivity type;
a step for selectively forming a first diffusion layer of the first conductivity type having a low dopant concentration on the second epitaxial layer;
a step for forming a second diffusion layer of the second conductivity type having a high dopant concentration at an upper section of the first diffusion layer; and
a step for selectively forming the transistor in the second epitaxial layer, wherein
the first and second diffusion layers constitute the light receiving element.

Each of the first conductivity type and the second conductivity type denotes either the p type or n type of a semiconductor. In the case where the first conductivity type is the p type, the second conductivity type is the n type. In the case where the first conductivity type is the n type, the second conductivity type is the p type (the same applying hereinafter) .

According to the constitution, the combination of the first diffusion layer of a first conductivity type having a low dopant concentration and the second diffusion layer of a second conductivity type having a high dopant concentration formed at the upper section of the first diffusion layer constitutes the diffusion layer in the light receiving element. Therefore, a substantially complete depletion of the receiving element portion can be realized when the depth of the second diffusion layer is reduced, and the percentage of the recombination of the carriers is lessened because the optical current is dominated by the drift current. As a result, a high speed and a high receiving sensitivity can be realized.

2) A second optical semiconductor device according to the present invention is an optical semiconductor device provided with a light receiving element and a transistor on the same substrate, comprising:
an embedding layer of a first conductivity type having a high dopant concentration formed at an upper section of a semiconductor substrate of the first conductivity type;
a first epitaxial layer of the first conductivity type having a low dopant concentration formed on the embedding layer;
a second epitaxial layer of a second conductivity type having a low dopant concentration formed on the first epitaxial layer;
a first diffusion layer of the first conductivity type having a low dopant concentration selectively formed on the second epitaxial layer; and
a second diffusion layer of the second conductivity type having a high dopant concentration formed at an upper section of the first diffusion layer, wherein
the first and second diffusion layers constitute the light receiving element, and the transistor is formed in the second epitaxial layer.

A method for manufacturing an optical semiconductor device corresponding to the second semiconductor device is a method for manufacturing an optical semiconductor device provided with a light receiving element and a transistor on the same substrate, comprising:
a step for forming an embedding layer of a first conductivity type having a high dopant concentration at an upper section of a semiconductor substrate of the first conductivity type;
a step for forming a first epitaxial layer of the first conductivity type having a low dopant concentration on the embedding layer;
a step for forming a second epitaxial layer of a second conductivity type having a low dopant concentration on the first epitaxial layer;
a step for selectively forming a first diffusion layer of the first conductivity type having a low dopant concentration on the second epitaxial layer;
a step for forming a second diffusion layer of the second conductivity type having a high dopant concentration at an upper section of the first diffusion layer; and
a step for selectively forming the transistor in the second epitaxial layer, wherein
the first and second diffusion layers constitute the light receiving element.

According to the constitution, a potential barrier is formed between the semiconductor substrate and the embedding layer of the first conductivity type having a high dopant concentration. The light absorbed in the semiconductor substrate fails to pass the potential barrier, and the carriers are thereby recombined, which reduces the diffusion current components. When a low concentration and an appropriate film thickness are selected for the first epitaxial layer of the first conductivity type having a low dopant concentration and the first diffusion layer of the first conductivity type having a low dopant concentration, a complete depletion can be realized, and a higher speed can be achieved. Further, because the embedding layer of the first conductivity type having a high dopant concentration is provided, a series resistance in the case where the carriers move toward the anode is reduced, which further improves the speed.

3) In the constitutions in 1) and 2), preferably, a well layer of a second conductivity type selectively formed in the second epitaxial layer is further provided, and the transistor is formed in the well layer. As a method for manufacturing an optical semiconductor device corresponding to the foregoing constitution, a step for selectively forming a well layer of the second conductivity type in a region of the second epitaxial layer where the transistor is formed is further included in the manufacturing methods in 1) and 2) . In the case where the concentration of the well layer of the second conductivity type is set to be higher than that of the second epitaxial layer of the second conductivity type having a low dopant concentration in the foregoing constitution, a collector resistance of the transistor is reduced. As a result, the speed can be further improved.

4) In the constitutions in 1) and 2), preferably, a well layer of the first conductivity type selectively formed in the second epitaxial layer is further provided, and the transistor is formed in the well layer. As a method for manufacturing an optical semiconductor device corresponding to the foregoing constitution, a step for selectively forming a well layer of the first conductivity type in a region of the second epitaxial layer where the transistor is formed is further included in the manufacturing methods in 1) and 2). This constitution is effective for a vertical transistor. In the case where the well layer of the first conductivity type is thus formed apart from the first diffusion layer of the first conductivity type having a low dopant concentration, the concentration of the well layer of the first conductivity type can be increased. As a result, the collector resistance can be reduced, and a higher speed can be realized in the vertical transistor.

5) In the constitutions in 1) - 4), a peak of the dopant concentration of the first diffusion layer is preferably formed on a surface of the second epitaxial layer. In the case where the peak position of the concentration of the first-conductivity-type first diffusion layer having a low dopant concentration is formed on the surface of the second-conductive-type second epitaxial layer having a low dopant concentration, a concentration gradient is formed in the anode layer of the light receiving element, which forms a potential slope. As a result, the carriers' moving velocity in the depth direction of the second epitaxial layer increases, and the speed of the light receiving element can be further improved.

### EFFECT OF THE INVENTION

According to the optical semiconductor device and the method of manufacturing the optical semiconductor device provided by the present invention, when the depth of the second diffusion layer of a second conductivity type is reduced, a substantially complete depletion of the receiving element portion can be realized, and the optical current is dominated by the drift current. As a result, the percentage of the carriers which are recombined decreases, and a higher speed and a higher receiving sensitivity can be realized.

### BRIEF DESCRIPTION OF THE DRAWINGS

Fig. 1 is a sectional view illustrating a constitution of an optical semiconductor device according to a preferred embodiment 1 of the present invention.
Fig. 2 is a sectional view illustrating a constitution of an optical semiconductor device according to a preferred embodiment 2 of the present invention.
Fig. 3 is an illustration of a photodiode concentration profile in the optical semiconductor device according to the preferred embodiment 2.
Fig. 4 is a sectional view illustrating a constitution of an optical semiconductor device according to a preferred embodiment 3 of the present invention.
Fig. 5A is a process sectional view illustrating a method of manufacturing the optical semiconductor device according to the preferred embodiment 1.
Fig. 5B is aprocess sectional view illustrating the method of manufacturing the optical semiconductor device according to the preferred embodiment 1.
Fig. 5C is aprocess sectional view illustrating themethod of manufacturing the optical semiconductor device according to the preferred embodiment 1.
Fig. 5D is aprocess sectional view illustrating themethod of manufacturing the optical semiconductor device according to the preferred embodiment 1.
Fig. 5E is aprocess sectional view illustrating themethod of manufacturing the optical semiconductor device according to the preferred embodiment 1.
Fig. 6A is a process sectional view illustrating a method of manufacturing the optical semiconductor device according to the preferred embodiment 2.
Fig. 6B is aprocess sectional view illustrating the method of manufacturing the optical semiconductor device according to the preferred embodiment 2.
Fig. 6C is aprocess sectional view illustrating themethod of manufacturing the optical semiconductor device according to the preferred embodiment 2.
Fig. 6D is aprocess sectional view illustrating the method of manufacturing the optical semiconductor device according to the preferred embodiment 2.
Fig. 6E is aprocess sectional view illustrating themethod of manufacturing the optical semiconductor device according to the preferred embodiment 2.
Fig. 6F is aprocess sectional view illustrating the method of manufacturing the optical semiconductor device according to the preferred embodiment 2.
Fig. 7A is a process sectional view illustrating a method of manufacturing the optical semiconductor device according to the preferred embodiment 3.
Fig. 7B is aprocess sectional view illustrating themethod of manufacturing the optical semiconductor device according to the preferred embodiment 3.
Fig. 7C is aprocess sectional view illustrating themethod of manufacturing the optical semiconductor device according to the preferred embodiment 3.
Fig. 7D is aprocess sectional view illustrating themethod of manufacturing the optical semiconductor device according to the preferred embodiment 3.
Fig. 7E is aprocess sectional view illustrating themethod of manufacturing the optical semiconductor device according to the preferred embodiment 3.
Fig. 7F is aprocess sectional view illustrating themethod of manufacturing the optical semiconductor device according to the preferred embodiment 3.
Fig. 8 is a sectional view illustrating a constitution of a conventional optical semiconductor device.

### DESCRIPTION OF REFERENCE SYMBOLS

- 1: silicon substrate
- 2: photodiode
- 3: NPN transistor
- 4: p-type embedding layer
- 5: p-type epitaxial layer (first epitaxial layer)
- 6: n-type epitaxial layer
- 7: LOCOS isolation layer
- 8: cathode layer
- 9: cathode contact layer (second diffusion layer)
- 10: cathode electrode
- 11: anode embedding layer
- 12: anode contact layer
- 13: anode electrode
- 14: collector embedding layer
- 15: collector contact layer
- 16: collector electrode
- 17: base layer
- 18: base electrode
- 19: emitter layer
- 20: emitter electrode
- 21: first insulation film
- 22: second insulation film
- 23: light receiving surface
- 24: n-type epitaxial layer (second epitaxial layer)
- 25: anode layer (first diffusion layer)
- 26: n-type well layer
- 27: vertical PNP transistor
- 28: p-type collector embedding layer
- 29: p-type collector well layer
- 40: photodiode
- 41: NPN transistor
- 42: silicon substrate
- 43: p-type embedding layer
- 44: n-type embedding layer
- 45: n-type epitaxial layer (second epitaxial layer)
- 46: p-type anode diffusion layer (first diffusion layer)
- 47: n-type well layer
- 48: LOCOS isolation layer
- 49: cathode layer (second diffusion layer)
- 50: p-type embedding layer
- 51: p-type epitaxial layer(first epitaxial layer)
- 52: vertical PNP transistor
- 53: p-type collector embedding layer
- 54: p-type well layer

### PREFERRED EMBODIMENTS OF THE PRESENT INVENTION

### PREFERRED EMBODIMENT 1 OF OPTICAL SEMICONDUCTOR DEVICE

A preferred embodiment 1 of an optical semiconductor device according to the present invention is described referring to the drawings.

Fig. 1 is a sectional view illustrating a constitution of an optical semiconductor device according to the preferred embodiment 1. As illustrated in Fig. 1, 1 denotes a low concentration p-type silicon substrate, 2 denotes a photodiode, 3 denotes an NPN transistor, 7 denotes a LOCOS isolation layer, 9 denotes a cathode contact layer (second diffusion layer), 10 denotes a cathode electrode, 11 denotes an anode embedding layer, 12 denotes an anode contact layer, 13 denotes an anode electrode, 14 denotes a collector contact layer, 15 denotes a collector contact layer, 16 denotes a collector electrode, 17 denotes a base layer, 18 denotes a base electrode, 19 denotes an emitter layer, 20 denotes an emitter electrode, 21 denotes a first insulation film, 22 denotes a second insulation film, and 23 denotes a light receiving surface. These components are the same as those provided in a conventional structure.

Further, 24 denotes a low concentration n-type epitaxial layer (second epitaxial layer) formed on the silicon substrate 1, 25 denotes a low concentration p-type anode layer (first diffusion layer) formed by means of diffusion in the region of the photodiode 2 in the n-type epitaxial layer 24 so as to reach the silicon substrate 1, and 26 denotes a n-type well layer formed by means of diffusion in the region of the NPN transistor 3 in the n-type epitaxial layer 24.

An operation of the optical semiconductor device according to the present preferred embodiment thus constituted is described below.

A basic operation is the same as described referring to Fig. 8. An incident light entering through the light receiving surface 23 is absorbed by the cathode contact layer 9, anode layer 25 and silicon substrate 1, and electron-hole pairs are thereby generated. The electrons and the holes are diffused and drifted and thereby separated from each other, and respectively arrived at the cathode contact layer 9 and the anode embedding layer 11. Then, optical current is generated. In the case where the depth of the cathode contact layer 9 is at most 0.3 µm, and the concentration of each of the p-type silicon substrate 1 and the anode layer 25 is approximately 1 × 10¹⁴ cm⁻³, for example, an anode depletion layer is extended by approximately 10 µm, and most of the incident light having a wavelength shorter than 650 nm which is particularly used for DVD is absorbed in the depletion layer. In other words, diffusion current components are reduced and drift current components are dominant in the optical current; therefore, a high-speed response of the photodiode 2 can be realized. Further, the percentage of carriers which are recombined is reduced, which improves a receiving sensitivity.

In the present preferred embodiment, the collector embedding layer 14 and the n-type well layer 26 constitute a collector of the NPN transistor 3. When the concentration of the n-type well layer 26 is set to be higher than that of the n-type epitaxial layer 24, a collector resistance is lessened, and a high-speed characteristic can be realized.

More specifically, the photodiode 2 characterized in its high speed and high sensitivity and the high-speed transistor 3 can be formed on the same substrate, which realizes such a structure that can maximize the characteristic improvement of the respective elements. As a result, characteristics of the OEIC can be improved.

The present preferred embodiment is particularly effective for the light having a short wavelength in which an absorption coefficient is large. 95% of the carriers are absorbed in the depth of 0.8 µm in the blue light for BD (wavelength of 405 nm). Therefore, almost 100% of the carriers are absorbed provided that the thickness of the n-type epitaxial layer 24 is 1 µm. Further, a parasitic capacitance and a parasitic resistance are reduced in the NPN transistor 3;therefore, the n-type epitaxial layer 24 having a smaller thickness is advantageous in order to improve the speed. For example, such a high-speed characteristic that a frequency characteristic of the NPN transistor 3 is at least 15 GHz can be realized in the case where the thickness of n-type epitaxial layer 24 is 1 µm.

### PREFERRED EMBODIMENT 2 OF OPTICAL SEMICONDUCTOR DEVICE

A preferred embodiment 2 of the optical semiconductor device according to the present invention is described referring to the drawings.

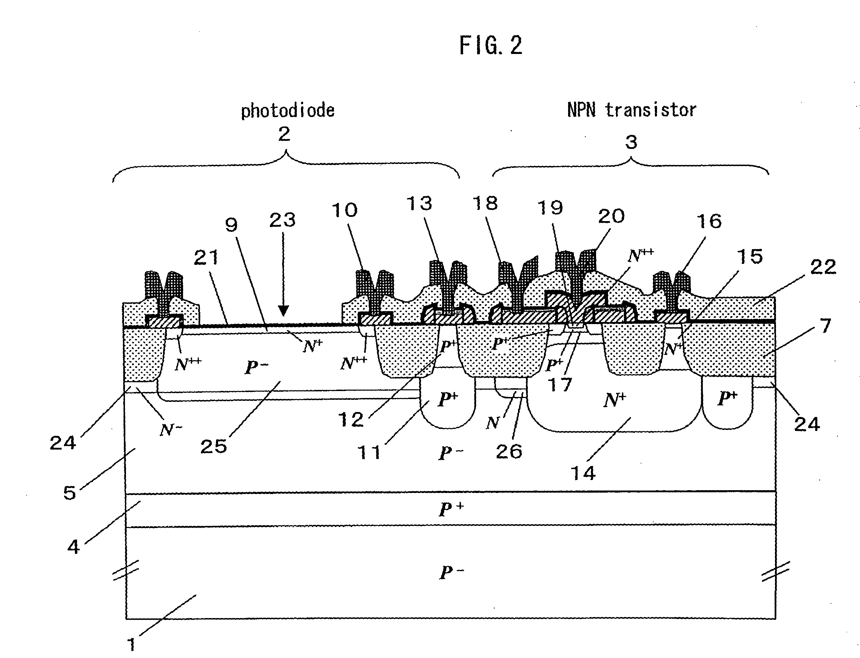

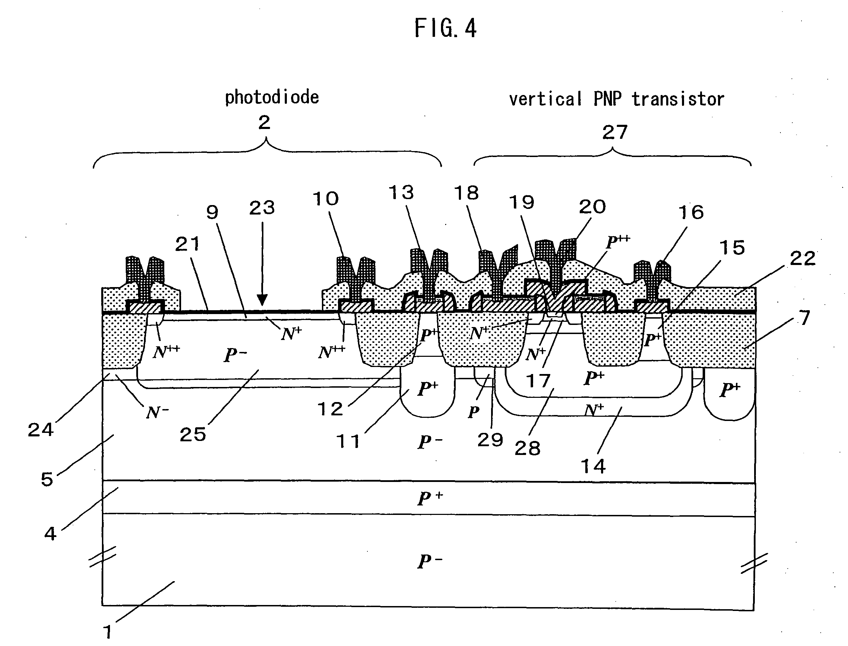

Fig. 2 is a sectional view illustrating a constitution of an optical semiconductor device according to the preferred embodiment 2. In Fig. 2, 4 denotes a high concentration p-type embedding layer formed on a silicon substrate 1, and 5 denotes a low concentration p-type epitaxial layer (first epitaxial layer) formed on the p-type embedding layer 4. The rest of the constitution is the same as that of the preferred embodiment 1.

The optical semiconductor device according to the present preferred embodiment is characterized in that the silicon substrate 1, p-type embedding layer 4 and p-type epitaxial layer 5 are used in place of the silicon substrate 1 according to the preferred embodiment 1.

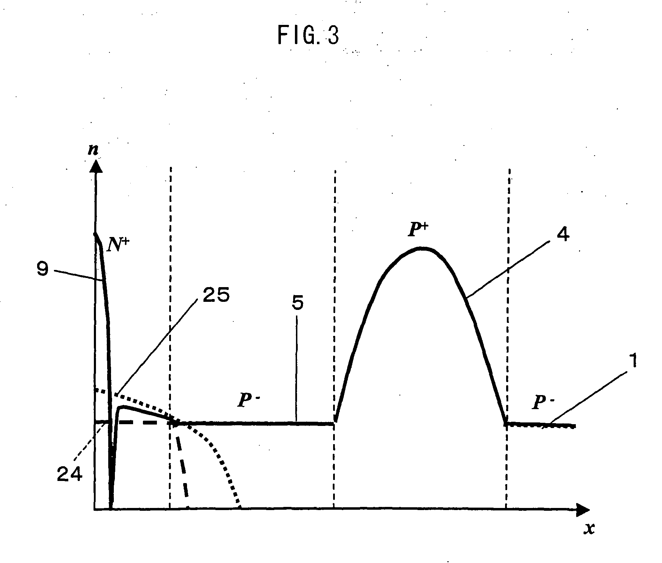

Fig. 3 shows a concentration profile in the depth direction of the photodiode 2. Numerals shown in the drawing are the same as those shown in Fig. 2.

The constitution according to the present preferred embodiment is advantageous in that, in addition to the effect according to the preferred embodiment 1, a potential barrier is formed between the silicon substrate 1 and the p-type embedding layer 4, and the light absorbed in the silicon substrate 1 fails to pass the potential barrier and the carriers are thereby recombined, which results in the reduction of the diffusion current components. A complete depletion can be realized and the speed can be improved when a low concentration and an appropriate film thickness are selected for the p-type epitaxial layer (first epitaxial layer) 5 and the anode layer (first diffusion layer) 25. Further, a series resistance in the case where the carriers move toward the anode embedding layer 11 in the presence of the p-type embedding layer 4 is lessened, which leads to the realization of a higher speed.

When a peak position of the concentration of the anode layer (first diffusion layer) 25 is formed on the surface of the n-type epitaxial layer (second epitaxial layer) 24, a concentration gradient is formed in the anode layer 25 as illustrated in Fig. 3. Accordingly, a potential slope is formed, and the carriers' moving velocity in the depth direction of the p-type epitaxial layer (first epitaxial layer) 5 increases. As a result, the photodiode 2 can achieve a higher speed.

### PREFERRED EMBODIMENT 3 OF OPTICAL SEMICONDUCTOR DEVICE

A preferred embodiment 3 of an optical semiconductor device according to the present invention is described referring to the drawings.

Fig. 4 is a sectional view illustrating a constitution of an optical semiconductor device according to the preferred embodiment 3. In Fig. 4, 27 denotes a vertical PNP transistor, 28 denotes a high concentrationp-type collector embedding layer, and 29 denotes a p-type collector well layer.

1 denotes a low concentration p-type silicon substrate, 2 denotes a photodiode, 4 denotes a p-type embedding layer, 5 denotes a p-type epitaxial layer, 7 denotes a LOCOS isolation layer, 9 denotes a cathode contact layer, 10 denotes a cathode electrode, 11 denotes an anode embedding layer, 12 denotes an anode contact layer, 13 denotes an anode electrode, 14 denotes a high concentration n-type collector embedding layer, 15 denotes a collector contact layer, 16 denotes a collector electrode, 17 denotes a base layer, 18 denotes a base electrode, 19 denotes an emitter layer, 20 denotes an emitter electrode, 21 denotes a first insulation layer, 22 denotes a second insulation layer, and 23 denotes a light receiving surface. These components are the same as those provided in the conventional structure.

The present preferred embodiment is characterized in that the vertical PNP transistor 27 is provided in place of the NPN transistor 3 according to the preferred embodiment 2.

The anode layer 25 can also serve as the p-type collector well layer 29. In the case where the p-type collector well layer 29 and the anode layer 25 are separately formed, the concentration of the p-type collector well layer 29 can be increased. As a result, the collector resistance is lessened, and a high speed can be realized in the vertical PNP transistor 27.

Therefore, in the constitution according to the present preferred embodiment, the photodiode characterized in its high speed and high receiving sensitivity and the high-speed vertical PNP transistor can be provided on the same substrate.

### METHOD FOR MANUFACTURING THE OPTICAL SEMICONDUCTOR DEVICE ACCORDING TO THE PREFERRED EMBODIMENT 1

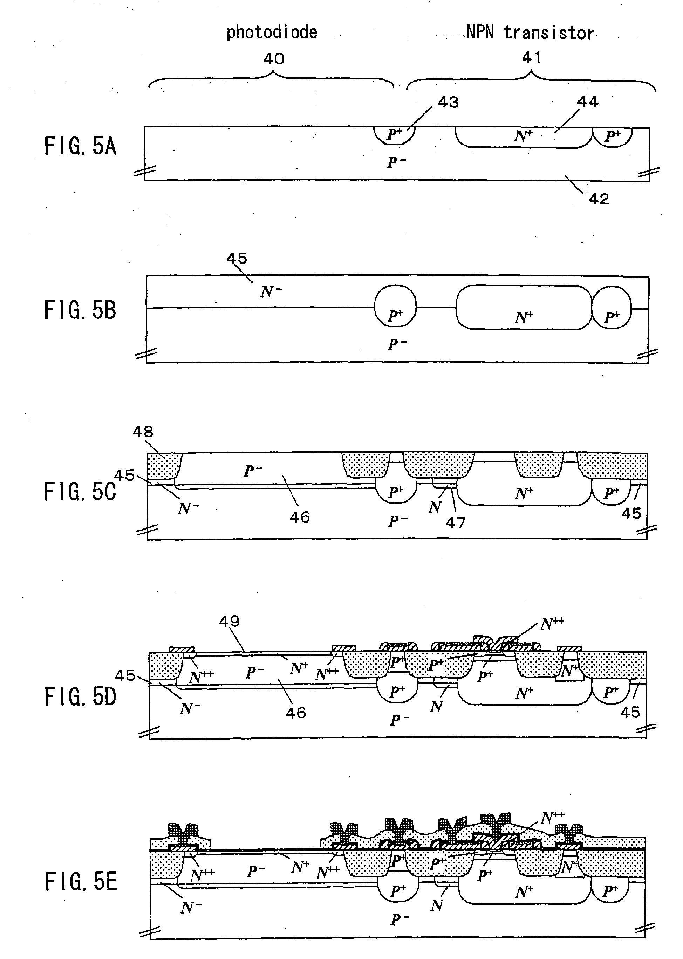

Figs. 5A - 5E are sectional views illustrating processing steps according to the preferred embodiment 1 in a method for manufacturing the optical semiconductor device according to the present invention. 40 denotes a photodiode, 41 denotes an NPN transistor, 42 denotes a low concentration p-type silicon substrate, 43 denotes a p-type embedding layer, 44 denotes an n-type embedding layer of a collector of the NPN transistor 41, 45 denotes a low concentration n-type epitaxial layer (second epitaxial layer), 46 denotes a low concentrationp-type anode diffusion layer (first diffusion layer), 47 denotes an n-type well layer having a concentration higher than that of the n-type epitaxial layer (second epitaxial layer) 45, 48 denotes a LOCOS isolation layer, and 49 denotes a high concentration n-type cathode layer (second diffusion layer) .

First, the p-type embedding layer 43 and the n-type embedding layer 44 are selectively formed in the silicon substrate 42 by means of the ion implantation or the like (see Fig. 5A).

Next, the n-type epitaxial layer (second epitaxial layer) 45 (for example, film thickness: approximately 1 µm, concentration:approximately 1×10¹⁴ cm⁻³) is grown on the silicon substrate 42 (see Fig. 5B).

Next, the p-type anode diffusion layer (first diffusion layer) 46 (for example, dopant: B (boron), 100 keV, dosing amount: 1 × 10¹¹ cm⁻²) is selectively formed in the region of the photodiode 40 in the n-type epitaxial layer (second epitaxial layer) 45, and the n-type well layer 47 (for example, dopant: P (phosphorous), 100 keV, dosing amount: 1 × 10¹² cm⁻²) is selectively formed in the region of the NPN transistor 41, both by means of the ion implantation or the like. After that, the LOCOS isolation layer 48 is formed (see Fig. 5C).

Further, the cathode layer (second diffusion layer) 49 and a base / emitter diffusion layer of the NPN transistor 41 are formed on the p-type anode diffusion layer (first diffusion layer) 46, on the n-type well layer 47, respectively (see Fig. 5D) . Finally, field films and electrodes are formed so that the photodiode 40 and the NPN transistor 41 are formed (see Fig. 5E).

Below is given the summary of the processing steps described so far.

A method for manufacturing the optical semiconductor device provided with the light receiving element 40 and the NPN transistor 41 on the same substrate 42, comprising:
a step for forming the second epitaxial layer 45 of a second conductivity type (n-type) having a low dopant concentration on the semiconductor substrate 42 of a first conductivity type (p-type);
a step for selectively forming the first diffusion layer 46 of the first conductivity type (p-type) having a low dopant concentration on the second epitaxial layer 45;
a step for forming the second diffusion layer 49 of the second conductivity type (n-type) having a high dopant concentration at an upper section of the first diffusion layer 46; and
a step for selectively forming the NPN transistor 41 in the second epitaxial layer 45, wherein
the first diffusion layer 46 and the second diffusion layer 49 constitute the light receiving element 40.

### METHOD FOR MANUFACTURING THE OPTICAL SEMICONDUCTOR DEVICE ACCORDING TO THE PREFERRED EMBODIMENT 2

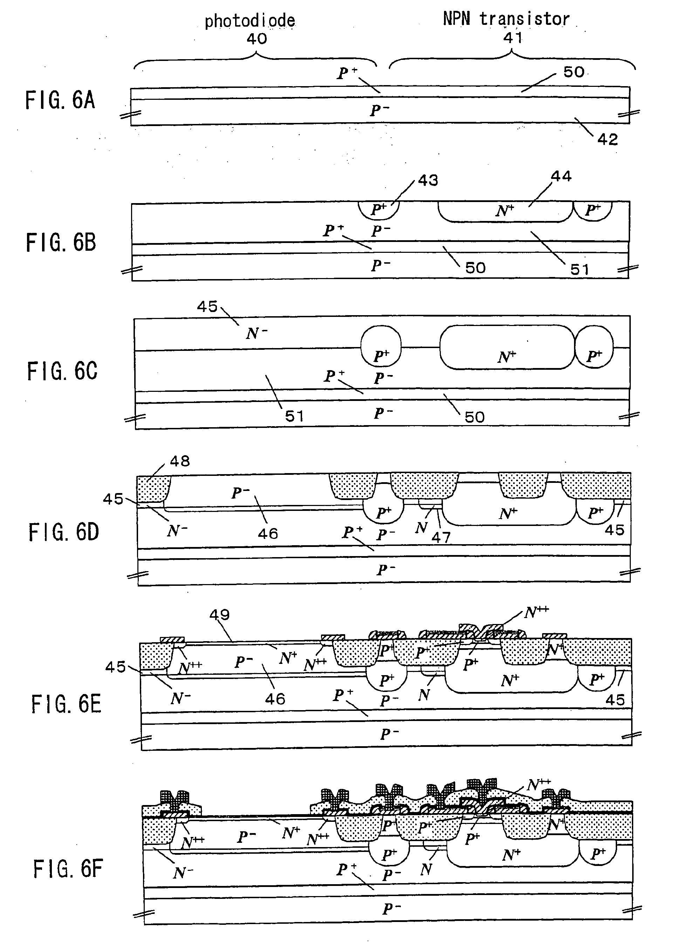

Figs. 6A - 6E are sectional views illustrating processing steps according to the preferred embodiment 2 in a method for manufacturing the optical semiconductor device according to the present invention. In Figs. 6, 50 denotes a high concentration p-type embedding layer, and 51 denotes a low concentration p-type epitaxial layer (first epitaxial layer). The rest of the constitution is the same as illustrated in Figs. 5.

First, the p-type embedding layer 50 is formed in the silicon substrate 42 by means of the ion implantation or the like. After that, the p-type epitaxial layer (first epitaxial layer) 51 is grown (see Figs. 6A and 6B).

Next, the p-type embedding layer 43 and the n-type embedding layer 44 are selectively formed in the p-type epitaxial layer (first epitaxial layer) 51 by means of the ion implantation or the like (see Fig. 6B).

Next, the n-type epitaxial layer (second epitaxial layer) 45 is grown on the p-type epitaxial layer (first epitaxial layer) 51 (see Fig. 6C).

Then, in the n-type epitaxial layer 45, the p-type anode diffusion layer (first diffusion layer) 46 and the n-type well layer 47 are formed in the region of the photodiode 40 and the region of the NPN transistor. 41, respectively. After that, the LOCOS isolation layer 48 is formed (see Fig. 6D).

Further, the cathode layer (second diffusion layer) 49 and the base / emitter diffusion layer of the NPN transistor 41 are formed on the p-type anode diffusion layer (first diffusion layer) 46, and on the n-type layer 47 respectively (see Fig. 6E). Finally, field films and electrodes are formed so that the photodiode 40 and the NPN transistor 41 are formed (see Fog. 6F).

The processing steps described so far are summarized below.

A method for manufacturing the optical semiconductor device provided with the light receiving element 40 and the NPN transistor 41 on the same substrate 42, comprising:
a step for forming the embedding layer 50 of a first conductivity type (p-type) having a high dopant concentration at an supper section of the semiconductor substrate 42 of the first conductivity type (p-type);
a step for forming the first epitaxial layer 51 of the first conductivity type (p-type) having a low dopant concentration on the embedding layer 50;
a step for forming the second epitaxial layer 45 of a second conductivity type (n-type) having a low dopant concentration on the first epitaxial layer 51;
a step for selectively forming the first diffusion layer 46 of the first conductivity type (p-type) halving a low dopant concentration on the second epitaxial layer 45;
a step for forming the second diffusion layer 49 of the second conductivity type (n-type) having a high dopant concentration at an upper section of the first diffusion layer 46; and
a step for selectively forming the NPN transistor 41 in the second epitaxial layer 45, wherein
the first diffusion layer 46 and the second diffusion layer 49 constitute the light receiving element 40.

### METHOD FOR MANUFACTURING THE OPTICAL SEMICONDUCTOR DEVICE ACCORDING TO THE PREFERRED EMBODIMENT 3

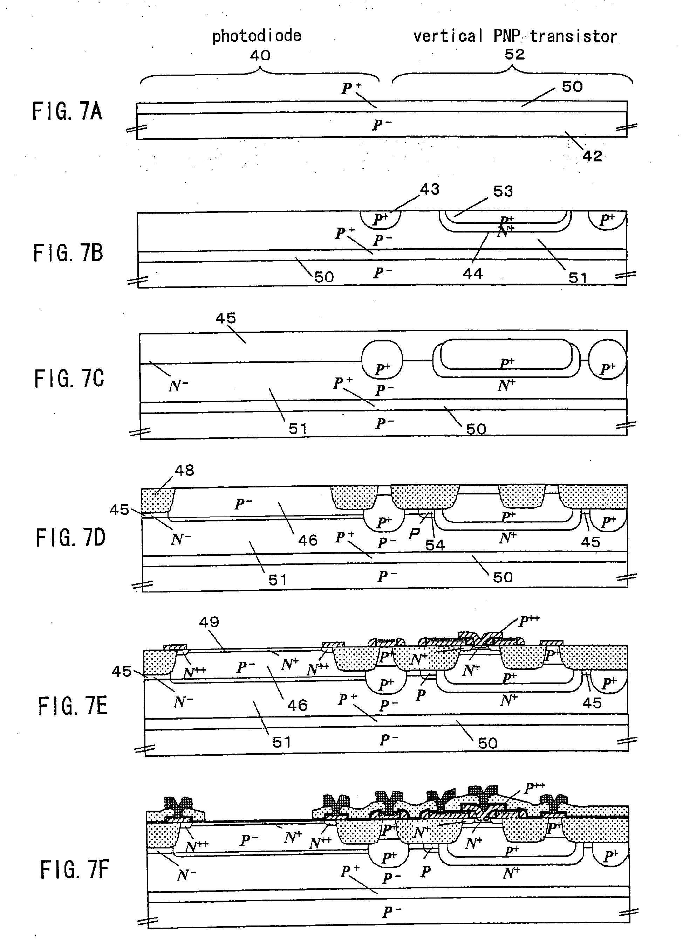

Figs. 7A - 7E are sectional views illustrating processing steps according to the preferred embodiment 3 in a method for manufacturing the optical semiconductor device according to the present invention. In Figs. 7, 52 denotes a vertical PNP transistor, 53 denotes a p-type collector embedding layer, and 54 denotes a p-type well layer. The rest of the constitution is the same as illustrated in Figs. 6.

First, the p-type embedding layer 50 is formed in the silicon substrate 42 by means of the ion implantation or the like. After that, the p-type epitaxial layer (first epitaxial layer) 51 is grown (see Figs. 7A and 7B).

Next, the p-type embedding layer 43, n-type embedding layer 44 andp-type collector embedding layer 53 are selectively formed in the p-type epitaxial layer (first epitaxial layer) 51 by means of the ion implantation or the like (see Fig. 7B). Here, the p-type embedding layer 43 and the p-type collector embedding layer 53 may be the same.

Next, the n-type epitaxial layer (second epitaxial layer) 45 is grown on the p-type epitaxial layer (first epitaxial layer) 51 (see Fig. 7C).

Then, in the n-type epitaxial layer (second epitaxial layer) 45, the p-type anode diffusion layer (first diffusion layer) 46 and the p-type well layer 54 are selectively formed in the region of the photodiode 40 and the region of the vertical PNP transistor 52, respectively, by means of the ion implantation or the like. After that, the LOCOS isolation layer 48 is formed (see Fig. 7D). Here, the p-type anode diffusion layer 46 and the p-type well layer 54 may be the same.

Further, the cathode layer (second diffusion layer) 49 and a base / emitter diffusion layer of the vertical NPN transistor 52 are formed on the p-type anode diffusion layer (first diffusion layer) 46, and on the p-type layer 54, respectively (see Fig. 7E). Finally, filed films and electrodes are formed so that the photodiode 40 and the vertical NPN transistor 52 are formed (see Fig. 7F).

In the present preferred embodiment, the silicon substrate is adopted. However, the substrate to be used is not necessarily limited thereto, and a germanium substrate or a compound substrate, which is used in a long wavelength region, for example, may be used.

In the present invention, the pin photodiode is used as the light receiving element; however, it is needless to say that an avalanche photodiode can be selected. Further, it is needless to say that the NPN or PNP bipolar transistor adopted as the transistor in this description can be replaced with an MOS transistor.

In the present invention, the semiconductor substrate and the first epitaxial layer are of p-type; however, may naturally be of n-type.

### INDUSTRIAL APPLICABILITY

The present invention is useful to a so-called OEIC in which a transistor characterized in its high speed and high performance and a light receiving element characterized in it high speed and high receiving sensitivity are integrated on the same substrate, and other similar types of integrated circuits.

## Claims

1. An optical semiconductor device a provided with a light receiving element and a transistor on the same substrate, comprising:
a second epitaxial layer of a second conductivity type having a low dopant concentration formed on a semiconductor substrate of a first conductivity type;
a first diffusion layer of the first conductivity type having a low dopant concentration selectively formed on the second epitaxial layer; and
a second diffusion layer of the second conductivity type having a high dopant concentration formed at an upper section of the first diffusion layer, wherein
the first and second diffusion layers constitute the light receiving element, and the transistor is formed in the second epitaxial layer.

2. An optical semiconductor device provided with a light receiving element and a transistor on the same substrate, comprising:
an embedding layer of a first conductivity type having a high dopant concentration formed at an upper section of a semiconductor substrate of the first conductivity type;
a first epitaxial layer of the first conductivity type having a low dopant concentration formed on the embedding layer;
a second epitaxial layer of a second conductivity type having a low dopant concentration formed on the first epitaxial layer;
a first diffusion layer of the first conductivity type having a low dopant concentration selectively formed on the second epitaxial layer; and
a second diffusion layer of the second conductivity type having a high dopant concentration formed at an upper section of the first diffusion layer, wherein
the first and second diffusion layers constitute the light receiving element, and the transistor is formed in the second epitaxial layer.

3. The optical semiconductor device as claimed in Claim 1, further comprising a well layer of the second conductivity type selectively formed in the second epitaxial layer, wherein
the transistor is formed in the well layer.

4. The optical semiconductor device as claimed in Claim 2, further comprising a well layer of the second conductivity type selectively formed in the second epitaxial layer, wherein
the transistor is formed in the well layer.

5. The optical semiconductor device as claimed in Claim 1, further comprising a well layer of the first conductivity type selectively formed in the second epitaxial layer, wherein
the transistor is formed in the well layer.

6. The optical semiconductor device as claimed in Claim 2, further comprising a well layer of the first conductivity type selectively formed in the second epitaxial layer, wherein
the transistor is formed in the well layer.

7. The optical semiconductor device as claimed in Claim 1, wherein
a peak of the dopant concentration of the first diffusion layer is formed on a surface of the second epitaxial layer.

8. The optical semiconductor device as claimed in Claim 2, wherein
a peak of the dopant concentration of the first diffusion layer is on a surface of the second epitaxial layer.

9. A method for manufacturing an optical semiconductor device a provided with a light receiving element and a transistor on the same substrate, comprising:
a step for forming a second epitaxial layer of a second conductivity type having a low dopant concentration on a semiconductor substrate of a first conductivity type;
a step for selectively forming a first diffusion layer of the first conductivity type having a low dopant concentration on the second epitaxial layer;
a step for forming a second diffusion layer of the second conductivity type having a high dopant concentration at an upper section of the first diffusion layer; and
a step for selectively forming the transistor in the second epitaxial layer, wherein
the first and second diffusion layers constitute the light receiving element.

10. A method for manufacturing an optical semiconductor device provided with a light receiving element and a transistor on the same substrate, comprising:
a step for forming an embedding layer of a first conductivity type having a high dopant concentration at an upper section of a semiconductor substrate of the first conductivity type;
a step for forming a first epitaxial layer of the first conductivity type having a low dopant concentration on the embedding layer;
a step for forming a second epitaxial layer of a second conductivity type having a low dopant concentration on the first epitaxial layer;
a step for selectively forming a first diffusion layer of the first conductivity type having a low dopant concentration on the second epitaxial layer;
a step for forming a second diffusion layer of the second conductivity type having a high dopant concentration at an upper section of the first diffusion layer; and
a step for selectively forming the transistor in the second epitaxial layer, wherein
the first and second diffusion layers constitute the light receiving element.

11. The method for manufacturing the optical semiconductor device as claimed in Claim 9, further including a step for selectively forming a well layer of the second conductivity type in a region of the second epitaxial layer where the transistor is formed.

12. The method for manufacturing the optical semiconductor device as claimed in Claim 10, further including a step for selectively forming a well layer of the second conductivity type in a region of the second epitaxial layer where the transistor is formed.

13. The method for manufacturing the optical semiconductor device as claimed in Claim 9, further including a step for selectively forming a well layer of the first conductivity type in a region of the second epitaxial layer where the transistor is formed.

14. The method for manufacturing the optical semiconductor device as claimed in Claim 10, further including a step for selectively forming a well layer of the first conductivity type in a region of the second epitaxial layer where the transistor is formed.
